# EUROPEAN PATENT APPLICATION

(11) **EP 0 836 223 A2**
(43) Date of publication of application: **15.04.1998**
(21) Application number: 97307951.0
(22) Date of filing: 08.10.1997
(51) Int. Cl.: H01L 21/28, H01L 21/285

(54) **Method of forming a silicide layer**

(30) Priority: 08.10.1996 US 28005 P
(71) Applicant: TEXAS INSTRUMENTS INC., Dallas, Texas 75243 (US)
(72) Inventor: Mizobuchi, Koichi, Dallas, Texas 75287 (US); Moroi, Masayuki, Richardson, Texas 75080 (US); Gotoh, Hideto, Niihari-Gun, Ibaraki 300-41 (JP)
(74) Representative: Williams, Janice

(57) **Abstract**

A method of forming a silicide layer 26 is disclosed herein. In one embodiment, a silicon region 10 such as a substrate or an epitaxial layer is provided. A silicon (e.g. polysilicon) layer 12 is formed over the silicon region 10 but insulated therefrom. A titanium layer 20 is then formed over the silicon layer 12. After the titanium layer 20 and underlying silicon layer 12 are patterned and etched, a cap layer 22 is formed. As examples, cap layer 22 may be an oxide or a nitride. The titanium and silicon layers 20 and 12 are then heated to form titanium silicide. The silicon region 10, however, will not react with the titanium layer 20.

## Description

### FIELD OF THE INVENTION

This invention relates generally to the fabrication of semiconductor devices and specifically to an improved silicide process.

### BACKGROUND OF THE INVENTION

As integrated circuits are made smaller, low resistivity materials are needed as interconnects. Metal silicides such as tungsten (W), titanium (Ti), molybdenum (Mo) and cobalt (Co) polycide are very attractive candidates. Titanium polycide is especially attractive since it indicates lowest resistivity.

Self-aligned silicide (or salicide) processes are presently used for lowering the resistivity of transfer gates and n- or p-type diffused layers. *See e.g.,* Science Forum Corp., "Ti SALICIDE Process," VLSI Process Data Book, p322. But as gate widths become narrower, very shallow junctions will be necessary to avoid short channel effects. Unfortunately, it is difficult to apply conventional titanium salicide processes to devices with shallow junction since the depth from the titanium silicide (TiSi₂) interface to the p-n (or n-p ) junction is marginal.

It is known that among refractory metal silicides, TiSi₂ is considered to be an optimal choice for applications such as contacts and interconnects on silicon MOS devices. The thin-film reaction of titanium on silicon often results in the formation of TiSi₂. The two different crystal structures of TiSi₂ most often observed in thin film reactions are the C49 and C54 types. The C49 structure is base-centered orthorhombic and the C54 structure is face-centered orthorhombic. The C54 phase is the only TiSi₂ phase which occurs in the binary-phase diagram, and therefore the C49 phase is considered to be metastable. In general, *see* Jeon et al., "Morphology and phase stability of TiSi₂ on Si," J. Appl. Phy. 71 (9), 1 May 1992, pp4269-76.

It is known to form a titanium silicide region with two annealing steps. For example, U.S. Patent 5,043,300 (which issued August 27, 1991 incorporated by reference herein) teaches depositing a titanium layer on a cleaned semiconductor wafer. The wafer is then moved from a vacuum deposition chamber to an annealing chamber being careful not to expose it to oxygen-bearing gases. Within the annealing chamber, the wafer is annealed in a nitrogen-bearing atmosphere for about 20 to 60 seconds at a temperature from about 500°C to about 695°C. This process step forms a titanium silicide layer and a layer of titanium nitride over the silicide. In addition, the titanium which had been deposited over silicon oxide surfaces is reacted to form titanium nitride. The wafer temperature is then raised to between about 800°C and 900°C to convert the titanium silicide to a stable phase. The wafer can then be etched to remove titanium nitride.

Another known process is the capped silicide process wherein the problems of oxygen contamination are avoided by covering the metal layer with a cap material prior to performing the silicide reaction. A process which uses a cap nitride is taught in U.S. Patent 4,940,509, incorporated herein by reference. In this teaching, a siliciding metal is deposited over exposed silicon portions of the wafer being fabricated. Five hundred angstroms of silicon nitride are then deposited over the metal and the device is heated to react the metal with the exposed silicon portions to form a metal silicide. The nitride layer can then be removed without adversely affecting the conductive properties of the silicide layer. If the silicide reaction temperature was less than 7000C, the two coexisting phases C49 and C54 of TiSi₂ will have been created. To attain a more satisfactory level of conductivity, the prior art reference teaches subjecting the wafer to a higher temperature anneal after stripping away the unsilicided reactants.

A number of self-aligned silicide (salicide) processes are disclosed in U.S. Patent No. 4,690,730 and in U.S. Patent 5,326,724. For example, the '730 patent teaches that pure titanium can be deposited over an FET device. A low temperature silicon nitride/silicon dioxide (NO) or silicon dioxide layer can then be deposited. The silicide is then reacted and the NO or SiO₂ layer is removed. After the unwanted Ti reaction products are removed, the silicide can be annealed.

### SUMMARY OF THE INVENTION

The present invention teaches a method of forming a titanium silicide region which overcomes many of the problems experienced by prior art methods. In one embodiment, a silicon region such as a substrate or an epitaxial layer is provided. A silicon (e.g., polysilicon) layer is formed over the silicon region but insulated from it. A titanium layer is then formed over the silicon layer. After the titanium layer and underlying silicon layer are patterned and etched, a cap layer is formed. This cap layer may be an oxide or a nitride and is preferably deposited by a PECVD process. The titanium and silicon layers are then heated to form titanium silicide. The silicon region, however, will not react with the titanium layer. The heating step may be performed in two steps with the cap layer being formed after the first heating step but before the second heating step.

This method can be used in a number of applications. For example, it is often desirable to silicide the gate of a field effect transistor but not the source/drain regions. As devices get smaller and smaller (e.g., with line widths of 0.25 microns and below), the gates become less conductive and therefore a method of increasing conductivity is needed. In these small devices, however, the source/drain regions are also often very shallow. If these shallow regions are silicided to the depth that the gate is silicided, the entire source/drain region may be consumed. Therefore, the present invention provides a solution to reduce the resistivity of the gate without adversely affecting the source/drain regions.

The present invention is especially useful in the fabrication of dynamic random access memories. By using the present invention, low resistivity titanium silicide (e.g., C54 phase) can be formed on the word lines and bit lines of a DRAM. By doing so, access speed can be improved. Speeding up the access speed can maximize the refresh capacity (i.e., the number of cells which can be refreshed at once) and reduce the area of peripheral circuitry. As a result, chip size can be reduced. Furthermore, the number of interconnect layers can be decreased by the application of this invention to the word lines and bit lines. Since metal interconnects over word/bit lines are often used for strapping the word/bit line, a low resistance material like TiSi₂ can eliminate the number of metal interconnects. This invention therefore offers cost reduction to DRAM manufacturing.

### BRIEF DESCRIPTION OF THE DRAWINGS

The above features of the present invention will be more clearly understood from consideration of the following descriptions in connection with accompanying drawings in which:
Figure 1 illustrates a prior art device to be silicided;
Figure 2 illustrates a device to be silicided according to the present invention;
Figures 3a-3f illustrate cross-sectional views of a first embodiment process;
Figures 4a-4b illustrate a memory cell and array which could utilize the method of the present invention;
Figures 5a-5g illustrate cross-sectional views of a second embodiment process;
Figures 6a-6f illustrate cross-sectional views of a third embodiment process;

Corresponding numerals and symbols in the different figures refer to corresponding parts unless otherwise indicated.

### DETAILED DESCRIPTION OF ILLUSTRATIVE EMBODIMENTS

The making and use of the various embodiments are discussed below in detail. However, it should be appreciated that the present invention provides many applicable inventive concepts which can be embodied in a wide variety of specific contexts. The specific embodiments discussed are merely illustrative of specific ways to make and use the invention, and do not limit the scope of the invention.

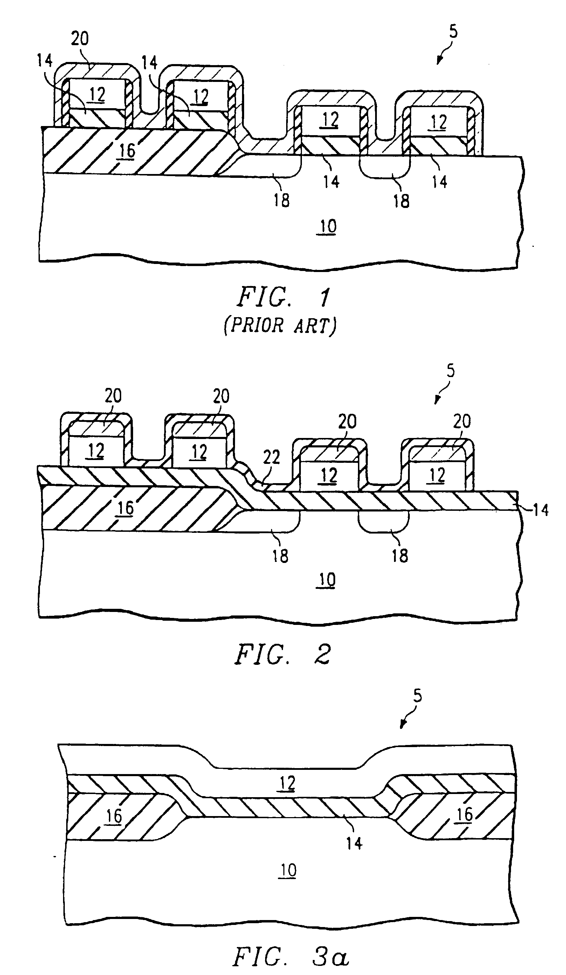

The present invention relates to a method of forming a silicide region. Before turning to the present invention, however, it will be useful to review a prior art process as depicted in Figure 1. Figure 1 has been provided to exemplify the known self-aligned silicide (salicide) process. A silicon substrate 10 is provided. A number of polysilicon structures 12 are formed over the substrate 10 and insulated therefrom by insulating region 14. In this example, two of the polysilicon structures 12 are formed over a field oxide region 16. Figure 1 also illustrates doped regions 18 which are formed within substrate 10 adjacent one of the polysilicon structures 12.

In order to create a silicide region, a refractory metal 20, such as titanium, is blanket deposited over the entire device 5. The metal layer 20 is then reacted with any exposed silicon regions to form a silicide. In this example, a silicide region (not shown) will be formed at the interface between the metal layer 20 and each of the polysilicon structures 12 as well as at the interface between metal layer 20 and the doped regions 18.

Unfortunately, the prior art process illustrated in Figure 1 has a number of disadvantages. Typically the silicide is reacted in a nitrogen ambient. In the case where layer 20 comprises titanium, the N₂ ambient disturbs the TiSi₂ formation due to nitration of Ti. In addition, use of this prior art process also causes the diffused layers 18 to be silicided. In the case of shallow junctions, junction leakage is a serious concern and silicidation of the shallow diffused regions may cause junction leakage.

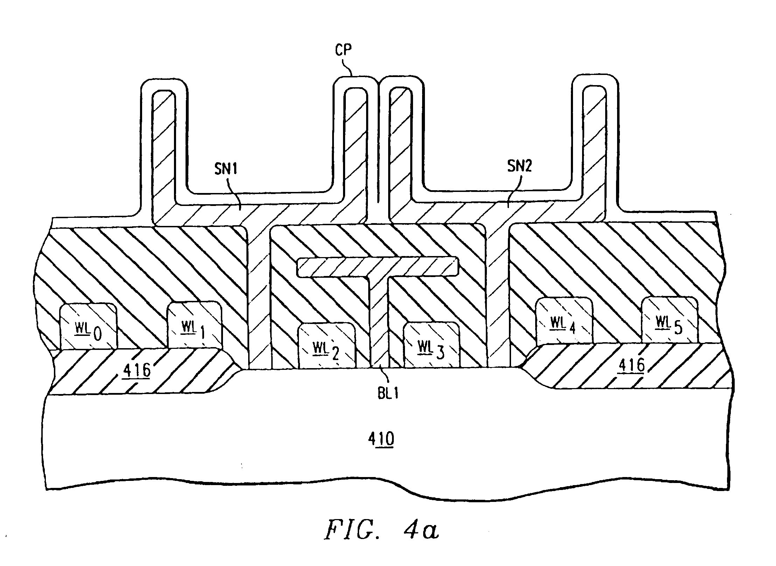

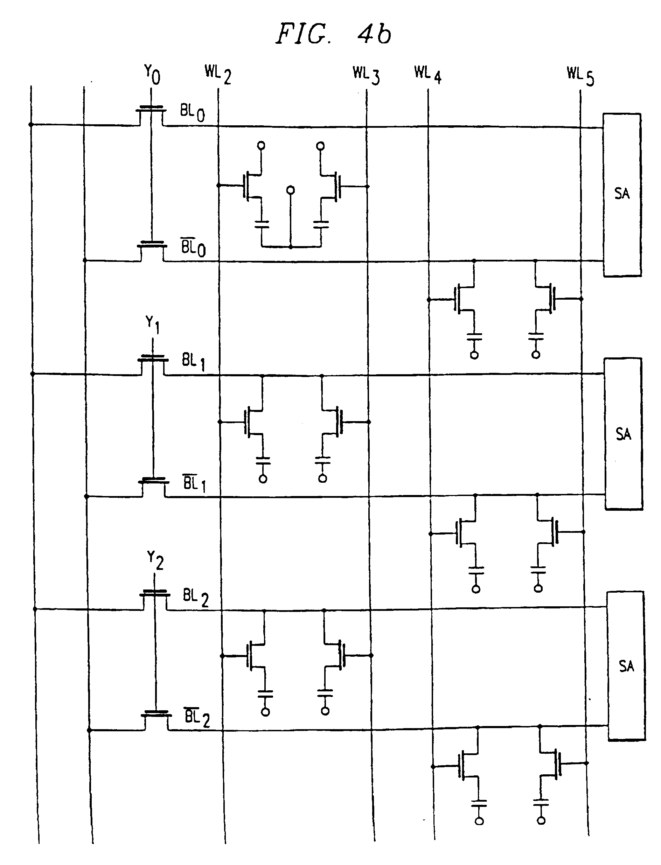

The present invention avoids many of the problems of the prior art processes. The present invention will first be described with respect to Figure 2. Figures 3a-3f will then describe the process as being used with the formation of a field effect transistor. After reviewing some details of a DRAM in Figures 4a and 4b, Figures 5a-5g and 6a-6f illustrate how the method of the present invention can be used to silicide the word lines and the bit lines of a DRAM (dynamic random access memory).

As with the prior art structure, device 5 of Figure 2 includes a number of silicon structures 12 formed over and insulated from semiconductor region 10 by dielectric layer 14 (preferably a 5 to 100Å thick oxide layer). Semiconductor region 10 is not limited to being a substrate. The region 10 can comprises a well (or tank or tub) formed in another semiconductor region, an epitaxial region, a semiconductor region over an insulator (e.g., SOI, SOS) or any other semiconductor region.

Silicon structures 12 can comprise just about any silicon structure but is preferably polycrystalline or amorphous silicon. For example, silicon structures 12 may represent the gate of a field effect transistor, a plate of a capacitor, an interconnect, a node of a diode, a contact, or other devices. The only limitation of structure 12 is that it is to be silicided.

Once again, doped regions 18 are included within the region 10 as well as field insulating region 16. These regions are included to demonstrate the versatility of the present invention.

In the method of the present invention, the refractory metal 20 is formed only over the semiconductor structures 12 which are selected to be silicided. It is noted that no metal 20 is formed over the doped regions 18. As will be discussed later, the metal layers are preferably patterned. In other words, this embodiment of the present invention does not utilize a self-aligned process.

In the preferred embodiment, the refractory metal is titanium. It should be noted, however, that other metals can also be used. In other embodiments, the refractory metal could be cobalt, molybdenum, palladium, platinum, or tungsten, as examples.

A cap layer 22 is disposed over the metal 20 and silicon 12. The cap layer 22 can comprise an oxide layer (e.g., SiO₂), a nitride layer (e.g., Si₃N₄) or a combination of the two (e.g., ON, ONO, NO, oxynitride). Other materials could also be used. The cap layer may be deposited using a CVD process such as PECVD.

When device 5 is heated to react metal 20 with semiconductor 12 a number of problems which occur in the prior art are avoided. For example, when a TiSi₂ region is formed, TiN formation in a nitrogen ambient is prevented and the titanium is fully consumed for TiSi₂ formation. Further, the phase change from C49 TiSi₂ to C54 TiSi₂ is simplified. In addition, TiSi₂ formation in the n or p type diffused layers 18 is prevented. This feature avoids the prior art junction leakage problems.

A number of examples of applications of the method of present invention will now be described. This first example will be illustrated in Figures 3a-3f. In this example, a field effect transistor (FET) will be fabricated. The gate of the FET will be silicided but the source and drain will not.

Referring now to Figure 3a, insulating layer 14 is formed over semiconductor region 10 and field insulating regions 16. Formation of field insulating regions are well known. In fact, the field insulating regions 16 need not be included. Other types of isolation such as trench isolation could be used instead. This aspect is simply not critical to the present invention.

Insulating layer 14 preferably comprises a silicon dioxide layer. This layer can be formed using known deposition techniques such as chemical vapor deposition (CVD). Other insulating layers such as nitride or combinations of oxides and nitrides can also be used.

Silicon layer 12 is formed over the semiconductor region 10. In the preferred embodiment, layer 12 comprises doped polycrystalline silicon. The layer 12 can be doped in situ or after it has been formed. In another embodiment, layer 12 need not be doped at all. In addition, it is noted that the layer 12 can alternatively comprise monocrystalline silicon (e.g., epitaxially grown) or amorphous silicon.

Referring next to Figure 3b, siliciding metal 20 is formed over the silicon layer 12. In the preferred embodiment, a titanium layer 20 is sputtered. But, as discussed before, other metals can alternatively be used. Further, refractory metals can be deposited by other methods.

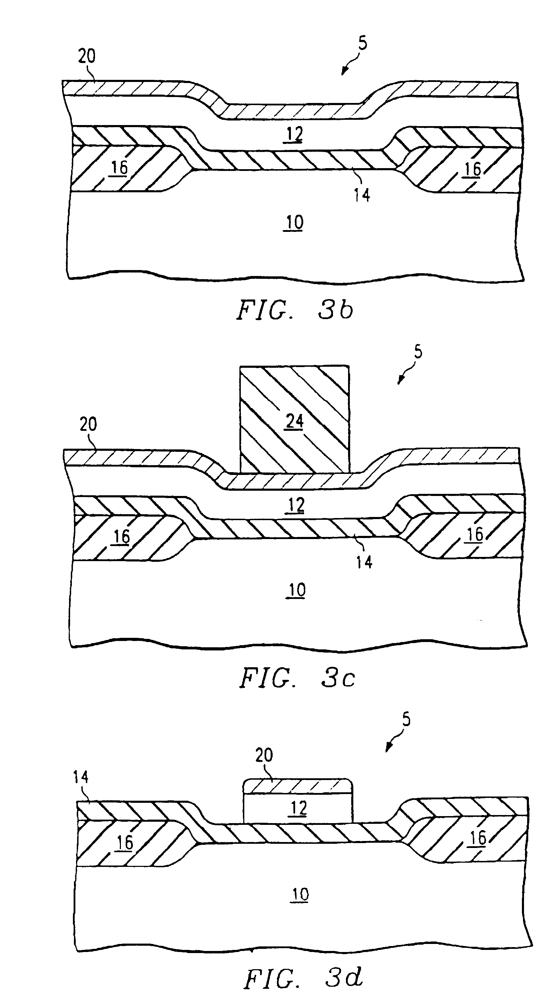

In Figure 3c, a photoresist layer 24 is formed over a portion of titanium layer 20 and silicon layer 12 where the gate will be formed. Any known (or yet to be developed) photolithography technique can be used to pattern the gate structure. In the preferred embodiment, a conventional dry etcher is used. The post-etch structure is illustrated in Figure 3d. In an alternate embodiment, the gate 12 is patterned and etched after which the metal layer 20 is selectively formed on that structure 12.

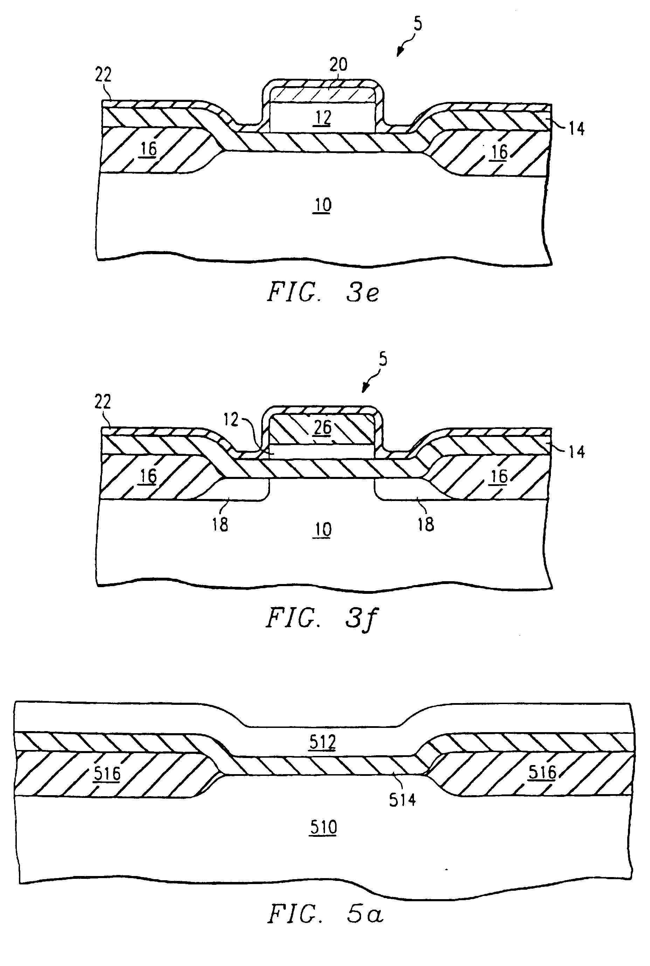

Referring now to Figure 3e, cap layer 22 is formed over device 5. In the preferred embodiment, cap layer 22 comprises either an oxide or nitride layer. For example, cap layer 22 may comprise P-TEOS silicon dioxide. It has been found that P-TEOS SiO₂ is suitable since it shows good step coverage. In one example, cap layer 22 is deposited at a relatively low temperature, e.g., under about 400°C.

In the next step, illustrated in Figure 3f, the silicide region 26 is formed by elevating the temperature. In the preferred embodiment, a two step anneal process is used. For example, the temperature is elevated to about 550°C to 600°C in an N₂ or H₂+N₂ ambient. C49 phase TiSi₂ is formed during this first annealing step. The second anneal step can be performed at temperatures over 660°C (e.g., about 700°C to 750°C). During this second heating step, the transition from C49 to C54 TiSi₂ can easily occur. This anneal step could also be used to perform additional functions such as annealing the doped regions 18 (see Figure 2).

In one embodiment, cap layer 22 is formed between the anneal steps. In other words, the device is heated to form silicide region 26 and then the cap layer 22 is formed, after which the second anneal step occurs. While it is most effective to deposit cap layer 22 prior to the first anneal, formation after the first anneal is still effective to avoid interaction of ambients (e.g., N₂, O₂, others) to the TiSiₓ (C49) surface. This order of steps is especially useful when trying to control the stress in the cap layer 22

There are a number of reasons we believe the transition from C49 to C54 phase occurs so easily. Formation of TiN in the N₂ ambient is prevented due to the use of the protective cap layer 22. As a result, the titanium 20 is fully consumed. If the Ti thickness is sufficient, C49-C54 transition can occur at the temperature around 700°C to 750°C. The phase transition of TiSi2 really depends on titanium thickness. For example, a paper related to the study of titanium silicidation reactions was published by Chen et al. in the Japan Journal of Applied Physics, Vol. 31, Feb. 1992, pp. 201-05 (in particular Figure 7), incorporated herein by reference. In this paper, the authors describe temperature of phase transition for various Ti thicknesses. Thicker Ti exhibited C49-C54 phase transition at relatively low temperatures. Thicker titanium, however, causes deep Ti diffusion into the silicon and also provides high stress. The impact on gate oxide integrity is a particular concern. Thus adequate Ti thickness has to be employed corresponding to thickness of Si layer 12.

In the preferred embodiment, adequate Ti thickness for varied thicknesses of silicon 12 is estimated in Table 1. The C49-C54 phase transition, however, also depends on free energy barrier of cluster. The width of the lines also influences the phase transition. It is noted that the minimum thicknesses noted in Table 1 may become needed for narrow line widths (e.g., under 0.35µm range).

**Table 1**

| Si Layer | Ti Thickness |
|---|---|
| 1000 Å | 300Å |
| 1500 Å | 300 - 500 Å |
| 2000 Å | 500 - 1000Å |

Another merit of this method is that silicide formation on the source/drain regions 18 is avoided. This feature is desirable to minimize junction leakage.

In addition, the phase transition of the TiSi₂ can further be completed by controlling the stress within the cap layer 22.

The co-pending application teaches control of the stress within the cap layer as a way to further simplify the formation of C54 phase TiSi₂.

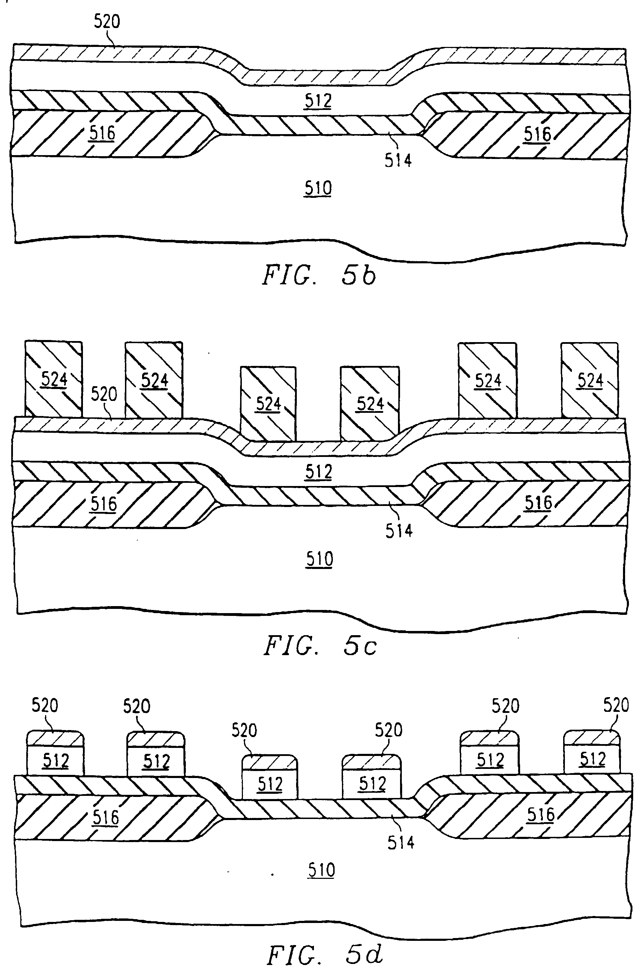

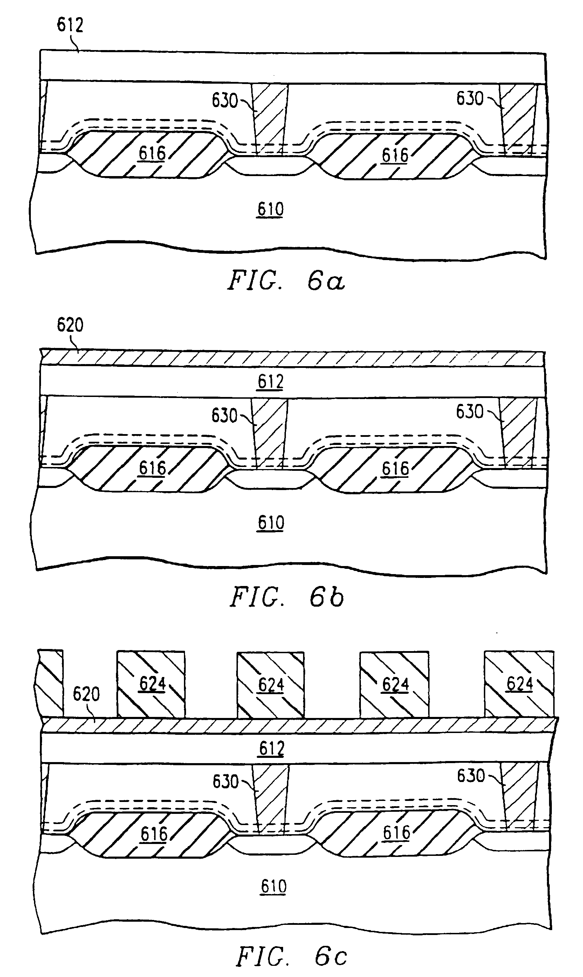

Another application of the present invention is illustrated in Figures 5a-5g and 6a-f which show selected steps in the fabrication of a DRAM. Figure 4a shows an exemplary DRAM cell and Figure 4b schematically illustrates an array of cells. In particular, Figures 5a-5g illustrate how the word lines of a DRAM can be silicided using the method of the present invention and Figures 6a-6f illustrate how the bit lines of a DRAM can be silicided using the method of the present invention.

Figure 4a illustrates a cross-sectional view of part of a single memory cell 8. As is known, a DRAM cell includes a pass transistor and a capacitor. The pass transistor includes a first semiconductor regions labeled SNC (for storage node contact), a second semiconductor region BLC (for bit line contact) and a transfer gate WL (for word line). Capacitor 20 includes a first plate SN (for storage node) and a second plate CP (for capacitor plate) separated by a capacitor dielectric.

The memory cell illustrated in Figure 4 is meant to be representative of all DRAM memory cells. Many alternative designs are available and the principles of the present invention will apply to many. In the present invention, a portion of the memory cell will be silicided. For example, the word lines WL and/or the bit lines BL can be silicided. Further, either capacitor plate (or both) could be silicided. The precise configuration of these and the other elements are not critical.

As illustrated in Figure 4b, a plurality of memory cells can be formed in an array of rows and columns. Figure 4b illustrates only six bit lines BL (three bit line pairs) and four word lines WL in what in actuality would likely be a much larger array. The pass transistor of each memory cell has a gate coupled to a word line WL and a source/drain region coupled to a bit line BL. Comparing the array of Figure 4b with the cross-sectional view of Figure 4a, if bit line BL1 is coupled to memory cells which are controlled hy word lines WL2 and WL3. In this example, word lines WL4 and WL5 are not illustrated schematically in Figure 4b.

Figure 4b also illustrates some of the peripheral circuitry which would be included in a memory array. For example, each pair of bit lines BL and BL(bar) is coupled to a sense amplifier SA. The bit lines BL and BL(bar) are also coupled to input/outline lines I/O and I/O(bar) through select transistors Y₀-Y₂. Other peripheral circuitry such as the row decoders, column decoders, address buffers, I/O buffers and so on are not illustrated here. As previously noted, the memory cell and fabrication method of the present invention are independent of the memory architecture.

As an example, the memory array can be designed as an asynchronous memory or as a synchronous memory. A synchronous memory can be timed with an internal clock or an external clock. The device can have a single external data terminal or multiple external data terminals (i.e., wide word). The array can include a total of four megabits, 16 megabits, 64 megabits, 256 megabits, one gigabit, or more.

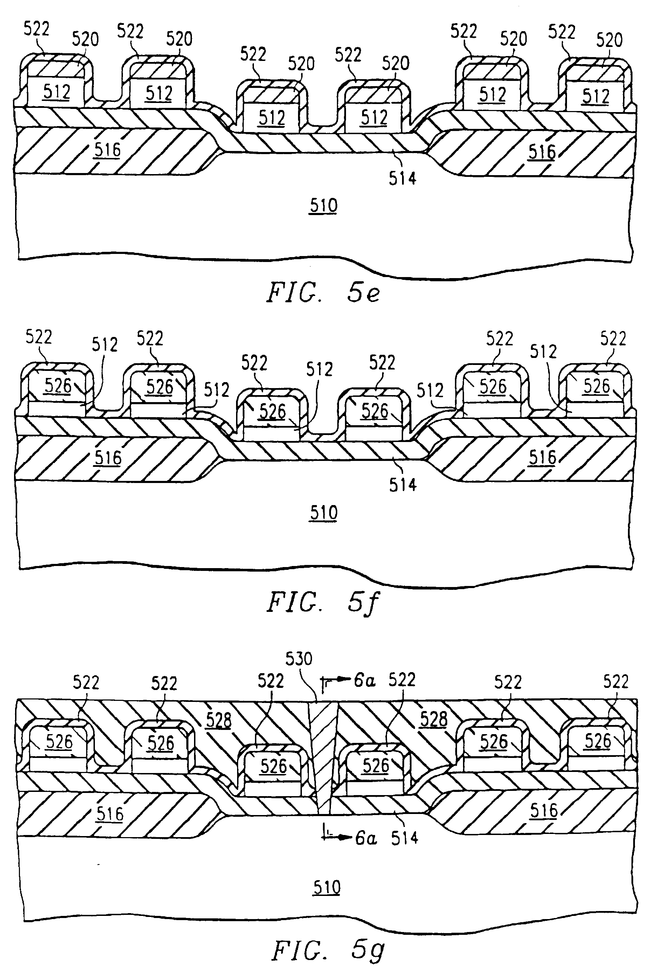

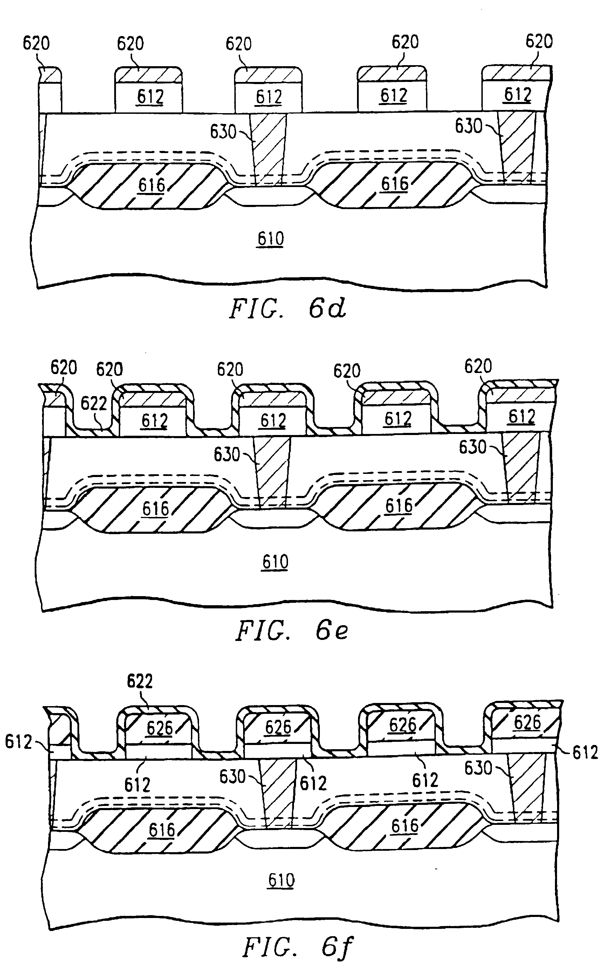

Silicidation of the word lines WL of a DRAM will be described first. Due to the similarity with siliciding the gate of an FET, the process will not be described in as great of detail. It is noted, however, that features discussed above with respect to the FET can also be applied to the DRAM (word line or bit line) and *vice versa.* In addition, for the sake of simplicity, the capacitor will not be shown in any of the illustrations of Figures 5 or 6. It should be understood that additional process steps will be included to form these and other elements in the device.

The first step in the process is to form the dielectric layer (gate oxide) 514 as shown in Figure 5a. In one embodiment, this step may be performed by thermally growing a silicon dioxide layer. To complete the structure of Figure 5a, polysilicon layer 512 is deposited.

Referring next to Figure 5b, a titanium film 520 is formed. For example, the film 12 may be sputtered. Next, a gate pattern is formed by a resist material 524 as shown in Figure 5c. In Figure 5d, the Ti/poly-Si 520/512 is etched, for example by using a conventional dry etcher.

After removing resist material 524, the cap layer 522 is formed as illustrated in Figure 3e. For example, a cap oxide 522 may be deposited using plasma enhanced SiO₂. As mentioned above, P-TEOS silicon dioxide is especially suitable since it shows a good step coverage.

Figure 5f illustrates the next step which is to form silicide region 526 on polysilicon layer 512 at an elevated temperature up to about 550°-600°C in N₂ or H₂+N₂ ambient. Titanium silicide of the C49 phase can be formed by this first annealing step. A second annealing can then be performed at about 700° to 750°C to form C54 phase TiSi₂.

As illustrated in figure 5g, a bit line contact hole 528 is opened by removing the material over bit line contact (not shown in Figure 5g, but may be a doped region 18 as illustrated in Figure 2). The bit line contact (not shown) may then be doped. A conductive plug 530 is formed within the bit line contact hole 528. In the preferred embodiment, conductive plug 530 is a polysilicon plug. In other embodiments, a metal plug can be used.

While the process of forming the word lines has been described by use of a specific example, it is noted that some or all of the variations discussed above with respect to Figures 3a-3f also apply to the process of Figures 5a-5g. For example, a metal material other than titanium can be used. As another example, the final anneal can be performed in one step (or three steps) rather than two.

Next, the formation of a DRAM with a Ti polycide bit line will be described with reference to Figures 6a-6f. It is noted that the cross-sectional views of Figures 6a-6f are taken along the lines XX in Figure 5g. In other words, the views of Figures 6a-6f will be going into and out of the page when viewing Figure 5g.

Referring now to Figures 6a and 6b, silicon layer 612 and metal layer 620 are deposited. Next, a bit line pattern is performed using a resist material 624 as shown in Figure 6c and then the Ti/poly-Si 620/612 is etched, e.g., using a conventional dry etcher. The patterned device is illustrated in Figure 6d.

After removing resist material 624, cap layer 622 is formed as illustrated in Figure 6e. In the preferred embodiment, a cap oxide 622 is deposited using plasma enhanced CVD. Plasma enhanced TEOS SiO₂ is suitable since it shows a good step coverage.

As shown in Figure 6f, Ti silicide 626 on poly Si 612 is formed by elevating the temperature to about 500° to 600°C in an N₂ or H₂+N₂ ambient. Once again, the anneal process can be performed in two steps. First, C49-TiSi₂ phase can be formed by the first annealing. A second anneal is then performed at about 700° to 750° C to form the lower resistance C54 TiSi₂. As before, the first anneal could be performed prior to formation of cap layer 622.

As described here, low resistivity titanium silicide (e.g., C54 phase) can be formed on the word lines and bit lines of a DRAM (dynamic random access memory). By doing so, access speed can be improved. Increasing the access speed can maximize the refresh capacity (i.e., the number of cells which can be refreshed at once) and reduce the area of peripheral circuitry. As a result, chip size can be reduced. Furthermore, the number of interconnect layers can be decreased by the application of this invention to the word lines and bit lines. Since metal interconnects over word/bit lines are often used for strapping the word/bit line, a low resistance material like TiSi₂ can eliminate the number of metal interconnects. This invention therefore offers cost reduction to DRAM manufacturing. While described in context of a dynamic RAM, the present invention is also applicable to other memory devices. SRAMs, EPROMs, EEPROMs, flash memories, and PROMs could each utilize the teachings of the present invention. As an example, an SRAM cell has bit lines which could be silicided. The cross-coupled gates of an SRAM cell could also be silicided.

While described herein with respect to specific process flows, other modifications are envisioned. In one example, the cap layer 22 can be either an oxide or nitride layer. Experimentation has shown that both SiO₂ and Si₃N₄ layers formed by dual frequency CVD as the cap layer 22 may be superior to layers formed by other processes, even though these other processes are still encompassed by the present invention. Experimentation has also shown that a plasma SiO₂ layer as a cap layer 22 may be superior to plasma Si₃N₄.

In addition, the present invention envisions a metal layer 20 which includes metal compounds. For example, a TiN or TiN/Ti layer 20 can be formed over the silicon layer 12. These layers 20/12 can then be reacted to form the silicide region.

The first and/or second heating steps can be performed in a furnace. For example the device can be heated at the appropriate temperature for a period between about 30 and 90 minutes. Alternatively,, rapid thermal processing (RTP) can also be utilized.

As demonstrated by the three examples, the method of the present invention can be applied to a variety of ULSI (or other) circuits. This process can be used to form a contact on the source, drain or gate of a MOS transistor device or a contact on other devices such as bipolar transistors, diodes, capacitors, resistors, and other elements. The present invention could also be used for interconnects between various elements within an integrated circuit. The process is especially well-suited for small lithographs such as .25 micron line widths.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A method of forming a titanium silicide region, said method comprising the steps of:
forming a silicon layer over a silicon region, said silicon layer being electrically insulated therefrom;
forming a metal layer over the silicon layer;
patterning and etching the metal layer and underlying silicon layer;
forming a cap layer over remaining portions of the metal layer and silicon layer; and
heating the metal layer and the silicon layer; such that the metal layer reacts with the silicon layer to form a silicide and the silicon region does not react with the metal layer.

2. The method of Claim 1, wherein the step of forming said metal layer comprises forming a refractory metal layer.

3. The method of Claim 2, wherein said step of forming said refractory metal layer comprises forming a titanium layer.

4. The method of any preceding claim further comprising performing the step of heating the metal and silicon layers in a first and a second heating step.

5. The method of Claim 4, wherein the step of forming said cap layer is performed after the first heating step but before the second heating step.

6. The method of any preceding claim, wherein the step of forming a cap layer comprises the step of depositing an oxide layer.

7. The method of Claim 6, wherein the step of forming the cap layer comprises forming a PECVD oxide.

8. The method of any preceding claim, wherein the step of forming a cap layer comprises the step of depositing a nitride layer.

9. The method of any preceding claim, wherein the steps of forming said silicide region are arranged for forming a gate of a transistor.

10. The method of any of Claims 1 to 9, wherein the steps of forming said silicide region are arranged for forming a word line of a memory device.

11. The method of any of Claims 1 to 9 wherein the steps of forming said silicide region are arranged for forming a bit line of a memory device.

12. A method of forming a silicide region, said method comprising the steps of:
forming a titanium layer over a silicon layer;
patterning and etching the titanium layer and the silicon layer;
annealing remaining portions of the titanium layer to form at least one titanium silicide region;
forming a cap layer over the at least one titanium silicide region; and
heating the at least one titanium silicide region and the cap layer such that the phase of the titanium silicide is changed.

13. The method of Claim 12, wherein the annealing step creates C49 phase titanium silicide and the heating step creates C54 phase titanium silicide.

14. The method of Claim 12 or Claim 13 wherein the step of forming said cap layer comprises forming an oxide layer.

15. The method of Claim 14, wherein the step of forming said cap layer comprises forming a PECVD oxide layer.

16. A method for forming a memory device, said method comprising the steps of:
forming a silicon layer over a silicon region but electrically insulated therefrom;
forming a titanium layer over and abutting the silicon layer;
patterning and etching the titanium layer and underlying silicon layer to form a plurality of word lines;
forming a cap layer substantially over each of the plurality of word lines; and
annealing each of the plurality word lines;
wherein the titanium layer reacts with the silicon layer to form titanium silicided word lines; and
the titanium layer does not react with the silicon region.

17. The method of Claim 16, further comprising performing the step of heating the titanium and silicon layers in a first and a second heating step.

18. The method of Claim 17, wherein the step of forming said cap layer is performed after the first heating step but before the second heating step.

19. The method of any of Claims 16 to 18 wherein the steps of forming said memory device are arranged for forming a DRAM device.

20. The method of any of Claims 16 to 18 wherein the steps of forming said device are arranged for forming a SRAM device.

21. The method of any of Claims 16 to 18 wherein the steps of forming said memory device are arranged for forming volatile device.

22. The method of any of Claims 16 to 21, further comprising the step of forming a plurality of bit lines wherein each of the plurality of bit lines is silicided.

23. A method for forming a synchronous dynamic random access memory device, said method comprising the steps of:
forming a silicon layer over a silicon region but electrically insulated therefrom;
forming a titanium layer over and abutting the silicon layer;
patterning and etching the titanium layer and underlying silicon layer to form a plurality of word lines, said plurality of word lines to serve as transfer gates for each of at least 64 million memory cells;
forming a cap layer each of the plurality of word lines; and
annealing each of the plurality word lines;
wherein the titanium layer reacts with the silicon layer to form titanium silicided word lines; and
the titanium layer does not react with the silicon region.
